# EUROPEAN PATENT APPLICATION

(11) **EP 2 391 192 A1**
(43) Date of publication of application: **30.11.2011**
(21) Application number: 11167392.7
(22) Date of filing: 25.05.2011
(51) Int. Cl.: H05K 1/02, H01L 23/367

(54) **Multilayer circuit substrate**

(30) Priority: 26.05.2010 JP 2010120850; 26.04.2011 JP 2011098638
(71) Applicant: JTEKT CORPORATION, Osaka-shi Osaka 542-8502 (JP)
(72) Inventor: Nagase, Shigeki, Osaka-shi, Osaka 542-8502 (JP)
(74) Representative: TBK

(57) **Abstract**

A multilayer circuit substrate (1) includes a substrate body (2) in turn including a plurality of conductor layers (11, 12, 13, 14) and a plurality of insulating layers (21, 22, 23) that are laminated alternately. The plurality of conductor layers include an uppermost conductor layer (11) that includes a plurality of conductor patterns (111, 112, 113, 114, 115, 116) and a lowermost conductor layer (14) that includes a plurality of conductor patterns (141, 142, 143, 144, 145, 146). A plurality of semiconductor devices (51, 52, 53, 54, 55, 56) are respectively mounted on the plurality of conductor patterns of the uppermost conductor layer (11). The plurality of conductor patterns of the lowermost conductor layer (14) includes a plurality of heat releasing patterns (141, 142, 143, 144, 145, 146). The plurality of heat releasing patterns is respectively provided in one-to-one correspondence with the plurality of semiconductor devices. Each of the heat releasing patterns has an area no less than an area of the corresponding semiconductor device. Each of the heat releasing patterns (141, 142, 143, 144, 145, 146) is connected to the corresponding semiconductor device (51, 52, 53, 54, 55, 56) via a corresponding heat releasing via (61).

## Description

### BACKGROUND OF THE INVENTION

### Field of the Invention

The present invention relates to a multilayer circuit substrate.

### Description of Related Arts

A multilayer circuit substrate proposed in Patent Document 1 (see, for example, Japanese Published Unexamined Patent Application No. 2008-182184) includes a laminated circuit portion, a metal substrate, and a heat releasing via. The laminated circuit portion is formed by alternately laminating a conductor layer and an insulating layer made of resin. The metal substrate is disposed in contact with the insulating layer that is a lowermost layer. A conductor layer is formed on an inner surface of the heat releasing via, and this conductor layer connects the conductor layer, which is an uppermost layer on which electronic parts are mounted, to the lowermost insulating layer.

Also, a multilayer circuit substrate in which a semiconductor bare chip is embedded is proposed in Patent Document 2 (see, for example, Japanese Published Unexamined Patent Application No. 2004-153084). A heat releasing pattern for heat release of the semiconductor bare chip is provided on a base material of a lowermost layer of the multilayer circuit substrate. The heat releasing pattern is formed integral to the semiconductor bare chip.

Also, a multilayer substrate proposed in Patent Document 3 (see, for example, Japanese Published Unexamined Patent Application No. 2005-260878) has dielectric layers on which a plurality of power amplifying circuits are mounted. Interference preventing grounding patterns respectively corresponding to the power amplifying circuits are disposed in a mutually separated manner on a dielectric layer corresponding to an upper layer or a lower layer among the dielectric layers. The interference preventing grounding patterns are connected via vias to a common grounding pattern provided on one of the dielectric layers.

By using a via, efficiency of heat release to a conductor layer that is a lowermost layer is improved. On the other hand, a level of heat release efficiency of a pathway for releasing heat from the conductor layer that is the lowermost layer to a metal plate via an insulating resin layer is a bottleneck for improving a heat release property of a multilayer circuit substrate as a whole.

An object of the present invention is to provide a multilayer circuit substrate with which a heat release property can be improved as a whole.

### SUMMARY OF THE INVENTION

A preferred mode of the present invention provides a multilayer circuit substrate that includes a substrate body in turn including a plurality of conductor layers and a plurality of insulating layers that are laminated alternately, and a plurality of heat releasing vias. The plurality of conductor layers include an uppermost conductor layer and a lowermost conductor layer. The uppermost conductor layer includes a plurality of conductor patterns on which a plurality of semiconductor devices are respectively mounted. The lowermost conductor layer includes a plurality of conductor patterns including a plurality of heat releasing patterns. The plurality of heat releasing patterns are respectively provided in one-to-one correspondence with the plurality of semiconductor devices. Each of the heat releasing patterns has an area no less than an area of the corresponding semiconductor device. Each of the heat releasing patterns is connected to the corresponding semiconductor device via a corresponding heat releasing via.

With the present preferredmode, heat can be released efficiently from the conductor patterns of the uppermost conductor layer, respectively having the semiconductor devices mounted thereon, to the respectively corresponding heat releasing patterns of the lowermost conductor layer via separate heat releasing vias. Moreover, the following merit is provided by the area of each of the heat releasing patterns of the lowermost conductor layer being made no less than the area of the corresponding semiconductor device on the corresponding conductor pattern of the uppermost conductor layer. That is, in a case where the present multilayer circuit substrate is supported by a heat releasing plate (for example, an aluminum plate or other metal plate) via an insulating resin layer, heat can be released efficiently to the heat releasing plate side from the heat releasing patterns of the lowermost conductor layer. The multilayer circuit substrate is thus improved in heat release property as a whole.

### BRIEF DESCRIPTION OF THE DRAWINGS

FIG. 1 is a diagrammatic sectional view of a multilayer circuit substrate according to a preferred embodiment of the present invention and corresponds to a sectional view taken along line I-I in FIG. 2.
FIG. 2 is a diagrammatic plan view of a multilayer circuit substrate.
FIG. 3 is a schematic plan view of a fourth conductor layer as a lowermost conductor layer of the multilayer circuit substrate.

### DETAILED DESCRIPTION OF THE PREFERRED EMBODIMENT

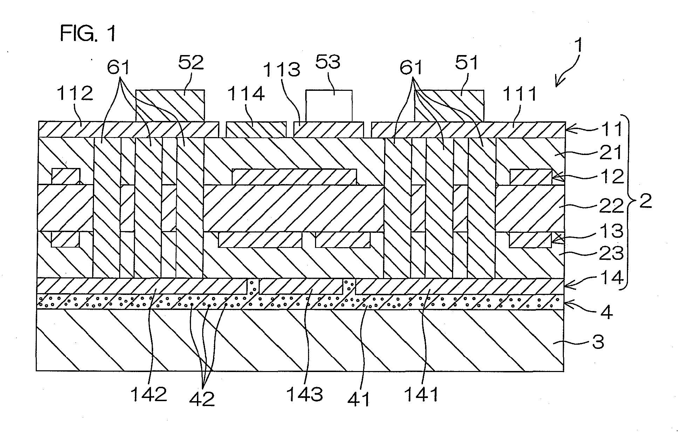

A preferred embodiment of the present invention shall now be described specifically with reference to the drawings. FIG. 1 is a sectional view of a multilayer circuit substrate according to a preferred embodiment of the present invention. As shown in FIG. 1, the multilayer circuit substrate 1 includes a substrate body 2 and a heat releasing plate 3 made, for example, of an aluminum plate. The substrate body 2 and the heat releasing plate 3 are connected via an adhesive layer 4 having an insulating property and having, for example, an epoxy resin as a main component.

The substrate body 2 includes a plurality of conductor layers 11 to 14 and a plurality of insulating layers 21 to 23 that are laminated alternately. That is, the substrate body 2 is formed by the first conductor layer 11 as an uppermost conductor layer, a first insulating layer 21, a second conductor layer 12, a second insulating layer 22, a third conductor layer 13, a third insulating layer 23, and a fourth conductor layer 14 as a lowermost conductor layer being laminated in that order.

Each of the conductor layers 11 to 14 may be formed of a metal, such as copper, aluminum, nickel, silver, titanium, gold, etc., or an alloy of such metals, or may be formed by application of nickel plating or nickel/goldplating on a surface of such a metal or a surface of an alloy of such metals. Each of the insulating layers 21 to 24 may be formed, for example, of a synthetic material of glass fibers and epoxy resin.

The adhesive layer 4 may, for example, be arranged by adding a thermal conductivity improving material 42 for increasing thermal conductivity to a base material 41 that includes an epoxy resin or other resin. The thermal conductivity improving material 42 is a powder or grains of a material with a high thermal conductivity coefficient. An insulating ceramic may be used as the thermal conductivity improving material 42. At least one material among aluminum nitride (AlN), aluminum oxide (Al203), silicon nitride (Si3N4), and silicon oxide (SiO2) may be used as the insulating ceramic.

In a case the insulating ceramic may be used as the thermal conductivity improving material 42, the thermal conductivity can thereby be increased while maintaining the insulating property of the adhesive layer 4. Consequently the heat releasing effect of the multilayer circuit substrate 1 as a whole can be improved.

Also, at least one of either a metal or carbon may be used as the thermal conductivity improving material 42. In general, a metal and carbon have electrical conductivity and are preferably added at an addition rate in a range that does not decrease an insulation resistance of the base material. The thermal conductivity can thereby be increased while maintaining the insulating property of the adhesive layer 4. At least one of either the metal or the carbon may be used with the insulating ceramic.

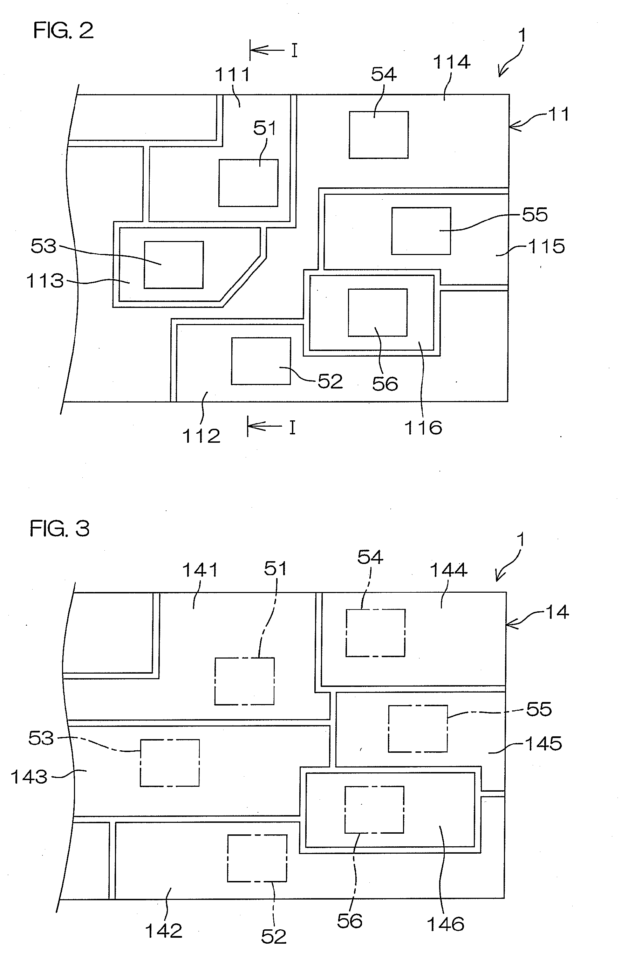

As shown in FIG. 2, the first conductor layer 11 as the uppermost conductor layer includes a first conductor pattern 111, a second conductor pattern 112, a third conductor pattern 113, a fourth conductor pattern 114, a fifth conductor pattern 115, and a sixth conductor pattern 116. Respectively corresponding semiconductor devices 51 to 56 are mounted on the respective conductor patterns 111 to 116.

That is, the first semiconductor device 51 is mounted on the first conductor pattern 111. The second semiconductor device 52 is mounted on the second conductor pattern 112. The third semiconductor device 53 is mounted on the third conductor pattern 113. The fourth semiconductor device 54 is mounted on the fourth conductor pattern 114. The fifth semiconductor device 55 is mounted on the fifth conductor pattern 115. The sixth semiconductor device 56 is mounted on the sixth conductor pattern 116. For example, each of the semiconductor devices 51 to 56 may be a bare chip of a switching device, such as a MOSFET, for driving an electric motor.

Also, as shown in FIG. 3, which is a schematic plan view, a first heat releasing pattern 141, a second heat releasing pattern 142, a third heat releasing pattern 143, a fourth heat releasing pattern 144, a fifth heat releasing pattern 145, and a sixth heat releasing pattern 146 are included as conductor patterns in the fourth conductor layer 14 as the lowermost conductor layer of the substrate body 2.

The respective conductor patterns 111 to 116 of the first conductor layer 11 as the uppermost conductor layer shown in FIG. 2 are connected in one-to-one correspondence to the respectively corresponding heat releasing patterns 141 to 146 of the fourth conductor layer 14 as the lowermost conductor layer shown in FIG. 3. In other words, each of the semiconductor devices 51 to 56 is correspondingly connected in one-to-one correspondence to the corresponding heat releasing pattern among the heat releasing patterns 141 to 146 of the fourth conductor layer 14 that is the lowermost layer.

That is, the first semiconductor device 51 is connected to the first heat releasing pattern 141 via a plurality of heat releasing vias 61. The second semiconductor device 52 is connected to the second heat releasing pattern 142 via a plurality of heat releasing vias 61. Also, although not illustrated, the third semiconductor device 53 is connected to the third heat releasing pattern 143 via a plurality of heat releasing vias. The fourth semiconductor device 54 is connected to the fourth heat releasing pattern 144 via a plurality of heat releasing vias. The fifth semiconductor device 55 is connected to the fifth heat releasing pattern 145 via a plurality of heat releasing vias. The sixth semiconductor device 56 is connected to the sixth heat releasing pattern 146 via a plurality of heat releasing vias.

In terms of improving thermal conduction to the heat releasing patterns 141 to 146 of the fourth conductor layer 14 as the lowermost conductor layer, it is preferable for each of the conductor patterns 111 to 116 of the first conductor layer 11 as the uppermost conductor layer to be connected to the corresponding heat releasing pattern among the heat releasing patterns 141 to 146 of the fourth conductor layer 14 as the lowermost conductor layer via the plurality of heat releasing vias 61.

Each heat releasing via 61 is arranged, for example, by filling a thermal via hole with a conductive metal material, such as copper. Also, a metal, such as aluminum, nickel, silver, titanium, gold, etc., or an alloy of such metals may be used in place of copper as the conductive metal material to be filled in the thermal via hole.

As shown in FIG. 3, an area of each of the heat releasing patterns 141 to 146 is made no less than an area of the corresponding semiconductor device among the semiconductor devices 51 to 56. That is, the area of the first heat releasing pattern 141 is greater than the area of the first semiconductor device 51. The area of the second heat releasing pattern 142 is greater than the area of the second semiconductor device 52. The area of the third heat releasing pattern 143 is greater than the area of the third semiconductor device 53. The area of the fourth heat releasing pattern 144 is greater than the area of the fourth semiconductor device 54. The area of the fifth heat releasing pattern 145 is greater than the area of the fifth semiconductor device 55. The area of the sixth heat releasing pattern 146 is greater than the area of the sixth semiconductor device 56.

Also, as shown in FIG. 3, the heat releasing patterns 141 to 146 are arranged so that when the semiconductor devices 51 to 56 are projected onto the fourth conductor layer 14 as the lowermost conductor layer, each of the heat releasing patterns 141 to 146 encompasses the projection image (indicated by alternate long and short dashed lines in FIG. 3) of the corresponding semiconductor device among the semiconductor devices 51 to 56.

Referring again to FIG. 1, the first conductor pattern 111 of the first conductor layer 11 as the uppermost conductor layer is connected to the first heat releasing pattern 141 of the fourth conductor layer 14 via the plurality of heat releasing vias 61. Likewise, the second conductor pattern 112 of the first conductor layer 11 is connected to the second heat releasing pattern 142 of the fourth conductor layer 14 via the plurality of heat releasing vias 61.

Although not illustrated in FIG. 1, each of the other conductor patterns 113 to 116 of the first conductor layer 11 is also connected via the corresponding heat releasing vias 61 to the corresponding heat releasing pattern among the heat releasing patterns 143 to 146 of the fourth conductor layer 14. With each heat releasing via 61, a conductor layer is formed on an inner surface of a hole penetrating from the first insulating layer 21 directly below the first conductor layer 11 to the third insulating layer 23 directly above the fourth conductor layer 14 as the lowermost conductor layer. Although not illustrated, a resin may be filled in an interior of the conductor layer formed on the inner surface of the hole.

With the present preferred embodiment, heat can be released efficiently from the respective conductor patterns 111 to 116 of the first conductor layer 11 as the uppermost conductor layer, on which the respective semiconductor elements 51 to 56 are mounted, to the respectively corresponding heat releasing patterns 141 to 146 of the fourth conductor layer 14 as the lowermost conductor layer via separate sets of the plurality of heat releasing via 61.

Moreover, the area of each of the heat releasing patterns 141 to 146 of the fourth conductor layer 14 as the lowermost conductor layer is made no less than the area of the respectively corresponding semiconductor device among the semiconductor devices 51 to 56 of the first conductor layer 11 as the uppermost conductor layer. Heat can thus be released efficiently from the respective heat releasing patterns 141 to 146 of the fourth conductor layer 14 as the lowermost conductor layer to the heat releasing plate 3 side via the adhesive layer 4 having the high thermal conductivity coefficient. The heat release property of the multilayer circuit substrate 1 as a whole is thus improved.

That is, the heat releasing effect of the multilayer circuit substrate 1 as a whole can be improved because the first to sixth heat releasing patterns 141 to 146 are connected to the heat releasing plate 3 via the adhesive layer 4, which is a resin layer with an insulating property.

Also, the semiconductor devices 51 to 56 are bare chips of switching devices, and thus heating of the switching devices to a high temperature can be prevented, and by using these switching devices, for example, an electric motor can be driven with stability.

The present invention is not restricted to the preferred embodiment described above, and for example, at least a portion of wiring vias may be used in common as the heat releasing vias.

While the present invention has been described in detail by way of a specific preferred embodiment, those skilled in the art, upon attaining an understanding of the foregoing, may readily conceive of alterations to, variations of, and equivalents to the preferred embodiment. Accordingly, the scope of the present invention should be assessed as that of the appended claims and any equivalents thereto.

This application corresponds to Japanese Patent Application Nos. 2010-120850 and 2011-98638, filed with the Japan Patent Office on May 26, 2010 and April 26, 2011, the entire disclosures of which are incorporated herein by reference.
A multilayer circuit substrate (1) includes a substrate body (2) in turn including a plurality of conductor layers (11, 12, 13, 14) and a plurality of insulating layers (21, 22, 23) that are laminated alternately. The plurality of conductor layers include an uppermost conductor layer (11) that includes a plurality of conductor patterns (111, 112, 113, 114, 115, 116) and a lowermost conductor layer (14) that includes a plurality of conductor patterns (141, 142, 143, 144, 145, 146). A plurality of semiconductor devices (51, 52, 53, 54, 55, 56) are respectively mounted on the plurality of conductor patterns of the uppermost conductor layer (11). The plurality of conductor patterns of the lowermost conductor layer (14) includes a plurality of heat releasing patterns (141, 142, 143, 144, 145, 146). The plurality of heat releasing patterns is respectively provided in one-to-one correspondence with the plurality of semiconductor devices. Each of the heat releasing patterns has an area no less than an area of the corresponding semiconductor device. Each of the heat releasing patterns (141, 142, 143, 144, 145, 146) is connected to the corresponding semiconductor device (51, 52, 53, 54, 55, 56) via a corresponding heat releasing via (61).

## Claims

1. A multilayer circuit substrate (1) comprising:
a substrate body (2) including a plurality of conductor layers (11, 12, 13, 14) and a plurality of insulating layers (21, 22, 23) that are laminated alternately; and
a plurality of heat releasing vias (61); and
wherein the plurality of conductor layers (11, 12, 13, 14) include an uppermost conductor layer (11) and a lowermost conductor layer (14),
the uppermost conductor layer (11) includes a plurality of conductor patterns (111, 112, 113, 114, 115, 116) on which a plurality of semiconductor devices (51, 52, 53, 54, 55, 56) are respectively mounted,
the lowermost conductor layer (14) includes a plurality of conductor patterns (141, 142, 143, 144, 145, 146) including a plurality of heat releasing patterns (141, 142, 143, 144, 145, 146),
the plurality of heat releasing patterns (141, 142, 143, 144, 145, 146) are respectively provided in one-to-one correspondence with the plurality of semiconductor devices (51, 52, 53, 54, 55, 56),
each of the heat releasing patterns (141, 142, 143, 144, 145, 146) has an area no less than an area of the corresponding semiconductor device (51, 52, 53, 54, 55, 56), and
each of the heat releasing patterns(141, 142, 143, 144, 145, 146) is connected to the corresponding semiconductor device (51, 52, 53, 54, 55, 56) via a corresponding heat releasing via (61).

2. The multilayer circuit substrate (1) according to Claim 1, wherein
the heat releasing patterns (141, 142, 143, 144, 145, 146) are connected to the heat releasing plate (3) via an insulating resin layer (4).

3. The multilayer circuit substrate (1) according to Claim 2, wherein
a thermal conductivity improving material (42) is added to the resin layer (4).

4. The multilayer circuit substrate (1) according to Claim 3, wherein
the thermal conductivity improving material (42) includes an insulating ceramic.

5. The multilayer circuit substrate (1) according to Claim 3, wherein
the thermal conductivity improving material (42) includes a metal or carbon.

6. The multilayer circuit substrate (1) according to any of Claims 1 to 5, wherein
each of the conductor patterns (111, 112, 113, 114, 115, 116) of the uppermost conductor layer (11) is connected to a heat releasing pattern (141, 142, 143, 144, 145, 146) corresponding to the conductor pattern (111, 112, 113, 114, 115, 116) of the uppermost conductor layer (11) via a plurality of the heat releasing vias (61).

7. The multilayer circuit substrate (1) according to Claims 1 to 6, wherein
the semiconductor device (51, 52, 53, 54, 55, 56) is a bare chip of a switching device.
